# EUROPÄISCHE PATENTSCHRIFT

(11) **EP 0 507 113 B1**
(45) Veröffentlichungstag und Bekanntmachung des Hinweises auf die Patenterteilung: **30.08.1995**
(21) Anmeldenummer: 92104063.0
(22) Anmeldetag: 10.03.1992
(51) Int. Cl.: C23C 14/34, C23C 14/20, G11B 7/24

(54) **Verfahren zur Beschichtung eines Werkstückes aus Kunststoff mit einer Metallschicht**
Method for coating a polymer substrate with a metal layer
Procédé de dépôt d'une couche métallique sur un substrat polymérique

(30) Priorität: 05.04.1991 CH 1038/91
(43) Veröffentlichungstag der Anmeldung: 07.10.1992
(73) Patentinhaber: BALZERS AKTIENGESELLSCHAFT, 9496 Balzers (LI)
(72) Erfinder: Jost, Stephan, Dr., CH-9477 Trübbach (CH); Strasser, Gregor, Dr., LI-9490 Vaduz (LI); Oesterle, Gerhard, A-6842 Koblach (AT)

(56) Entgegenhaltungen:
- EP-A- 0 151 861
- EP-A- 0 406 569
- DE-A- 3 919 145
- US-A- 4 028 206
- US-A- 4 957 603

## Beschreibung

Die vorliegende Erfindung betrifft ein Verfahren zur Beschichtung eines Werkstückes aus Kunststoff mit einer Metallschicht in einer Vakuumkammer mit Hilfe der Magnetron-Kathodenzerstäubung. Die metallische Schicht wird mit Hilfe des bekannten Kathodenzerstäubungsverfahrens in einer Vakuumkammer auf das Kunststoffwerkstück abgeschieden. Solche Schichten finden insbesondere Anwendung bei der Herstellung von Speicherplatten. Darunter fallen beispielsweise magetooptische Aufzeichnungsverfahren, wo die Information in der Schicht selbst gespeichert wird, wie auch optische Speicherverfahren, wo die Information in der Platte selbst eingeprägt ist und mit einer hochreflektierenden Schicht versehen ist, wobei ein Laserstrahl die Information entsprechend abtasten kann. Aus Kostengründen soll die Trägerplatte heute aus Kunststoffen bestehen. Die Beschichtung solcher Kunststoffe muss aber so erfolgen, dass die Schicht genügend haftfest auf der Unterlage verbleibt und wobei das Beschichtungsverfahren den Informationsträger nicht beschädigen darf. Kunststoffe sind, bezogen auf diese Anforderungen, besonders schwierig zu beschichten.

Zur Erhöhung der Haftung der nachfolgend aufgebrachten Metallschichten sind verschiedene Behandlungsmethoden bekannt. Die Behandlung der Kunststoffoberfläche mit Hilfe einer Plasmaentladung geht beispielsweise aus dem Vortrag von G. Legeay, "Surface Modification of naturel or synthetic polymers by cold plasmas" hervor gehalten an der 2. Conf. Plasma Chem. Tech. 1984. Die Oberfläche des Kunststoffträgers wird durch die Plasmabehandlung so modifiziert, dass eine nachfolgend aufgebrachte Schicht besser haftet. Für die Plasmabehandlung werden beispielsweise sauerstoff-, helium- und kohlenstoffhaltige Gase verwendet. Die Verwendung von Helium oder Sauerstoffplasmaentladungen zur Behandlung von Kunststoffoberflächen ist auch bekannt aus dem Fachaufsatz von J. Hall aus: J. Appl. Polym. Sci. Vol 13, 1969. Die Plasmabehandlung hat hierbei zum Ziel, eine verbesserte Verklebbarkeit von Kunststoffen zu ermöglichen. In einem weiteren Fachaufsatz von J. Hollahan, aus: J.Appl. Polym. Sci. Vol 13, 1969 ist bekannt geworden, Kunststoffe einer Plasmabehandlung auszusetzen mit amoniak-, stickstoff- und wasserstoffhaltigem Gas, zur Verbesserung der Oberfächenhaftung und der Benetzbarkeit. Verwendet wird bei dieser Anwendung eine Hochfrequenzplasmaentladung. Weiterhin ist ein Beschichtungsverfahren für optische Speicherplatten aus PMMA in der Patentschrift US 4,957,603 beschrieben worden. In dieser Schrift wird darauf hingewiesen, dass PMMA (Polymethylmetacrylat) Kunststoffe besonders schwierig zu beschichten sind bei Verwendung des Kathodenzerstäubungsverfahrens. Einerseits besteht das Problem, eine metallische Schicht abzuscheiden welche genügend auf der Unterlage haftet. Andererseits soll die Struktur der Kunststoffoberfläche nicht zerstört werden, so dass gespeicherte Informationen verloren gehen können oder eine schlechte Signalausbeute entsteht. Es wird offenbart, dass die Oberfläche durch Teilchenbombardement und Strahlung modifiziert und unzulässig verändert wird. Diese Bestrahlung rührt von der Plasmaentladung des Beschichtungsvorganges her. Zur Lösung dieses Problemes wird vorgeschlagen, zu Beginn des Beschichtungsvorganges Kohlenstoff hinzufügen, welches eine Veränderung der Oberflächenstruktur durch Strahlung verhindern soll.

Die vorbekannten Verfahren haben den Nachteil, dass mehrere Arbeitsschritte nötig sind und somit die Wirtschaftlichkeit entsprechend gering ist oder die Oberflächen zu stark modifiziert werden, so dass sie für viele Verwendungszwecke, insbesondere für Speicherplattenanwendungen, nicht brauchbar sind. Das Einfügen von Kohlenstoff zwischen die Unterlage und die aufgebrachte Metallschicht bedeutet neben einem zusätzlichen Prozessaufwand auch das Einbringen eines Fremdstoffes in den Beschichtungsprozess, welcher die Reinheit und somit die Qualität des Endproduktes ungünstig beeinflussen kann wobei dies zusätzlich an Aufwand bezüglich Anlagenkomplexität und Reinigungsaufwand bedeuten kann.

Weitere bekannte Verfahren zur Erhöhung der Haftfestigkeit, wie beispielsweise die Zwischenbeschichtung mit Oxyden oder Nitriden sind für Anwendungen wie für Speicherplatten ebenfalls nicht geeignet, da diese Beschichtungen und die Oberflächenstruktur des zu beschichtenden Werkstückes zu stark beeinflussen würden oder zusätzlichen unökonomischen Aufwand bedeuten.

Die vorliegende Erfindung hat sich nun zur Aufgabe gemacht, ein Beschichtungsverfahren für Metalle auf Kunststoffwerkstücke zu realisieren, welches mit hoher Wirtschaftlichkeit bei hoher Schichthaftung ausgeführt werden kann. Insbesondere soll dieses Verfahren erlauben besonders empfindliche Werkstücke, wie beispielsweise optische Speicherplatten mit einer Metallschicht, welche gut haftet, zu beschichten, ohne dass der Datenträger durch das Verfahren ungünstig beeinflusst wird. Diese Aufgabe wird erfindungsgemäss nach dem Verfahren gemäss dem Wortlaut der Ansprüche 1 bis 13 gelöst.

Die Beschichtung des Werkstückes aus Kunststoff mit einer Metallschicht erfolgt in einer Vakuumkammer mit Hilfe einer Magnetron- Kathodenzerstäubungseinrichtung. Solche Magnetronzerstäubungseinrichtungen sind seit langem bekannt und erlauben die Beschichtung mit hoher Effizienz. Bei der Magnetronkathodenzerstäubung wird eine Plasmaentladung in einem Druckbereich von ca. 10⁻² bis 10⁻³ mbar eines Edelgases, meistens Argon, erzeugt wobei die entstandenen Argonionen auf die Kathode beschleunigt werden und diese, welche aus dem zu zerstäubenden Material besteht, durch einen Stossvorgang zerstäubt, wodurch eine Schichtabscheidung auf ein Werkstück ermöglicht wird. Erfindungsgemäss erfolgt die Abscheidung der haftfesten Metallschicht ausschliesslich mit einer Magnetron- Zerstäubungseinrichtung, wobei das Plasma dieser Magnetron- Zerstäubungseinrichtung mit einem Gasgemisch aus Argon und mindestens einem weiteren Edelgas betrieben wird. Besonders geeignet sind Edelgase wie beispielsweise Helium oder Neon, welche eine geringere Masse aufweisen als Argon. Helium beispielsweise hat gegenüber dem Argon eine sehr geringe Zerstäubungsausbeute. Mit dieser Mischung kann die Zerstäubungsausbeute sowie das Verhalten der Ionisationsverhältnisse der beteiligten Gase kontrolliert werden. Durch das Einschleusen der Kunststoffwerkstücke wird eine gewisse Menge an Restgasen, wie Wasserdampf und Stickstoff in den Prozess mit eingebracht. Mit der Argon-Helium-Mischung ist es möglich, die Reaktion dieser Restgase mit dem abgestäubten Metall im ersten Moment des Zerstäubungsvorganges so zu kontrollieren, dass die Metalloxyde beziehungsweise Nitride, welche sich bilden, haftvermittelnd für die nachfolgende Metallschicht wirken. Diese günstige Haftungseigenschaften werden bewirkt ohne die Oberfläche des Kunststoffes im Mikrobereich unzulässig zu verändern. Für optische Speicherplatten beispielsweise dürfen die Strukturen mit Dimensionen im Bereich von 1 Mikrometer und kleiner, welche als Informationsträger dienen, nicht durch die haftvermittelnden Massnahmen oder die dem Zerstäubungsvorgang ausgesetzte Strahlung unzulässig verändert werden. Unzulässige Veränderungen sind beispielsweise zu starke Abdeckung des Informationsträgers oder beispielsweise Veränderungen von Kanten, welche zu einem schlechten Signalverhalten führen würden.

Wie erwähnt kann der Beschichtungsvorgang erfindungsgemäss sehr effizient mit derselben Quelle vorgenommen werden, ohne dass wie bei anderen bekannten Verfahren, eine zusätzliche Einrichtung zur Erzeugung einer Haftschicht eingesetzt werden muss. Eine weitere Optimierung des Abscheidevorganges ist möglich, wenn während dem Plasmaentladungsvorgang das Mischungsverhältnis der Helium-Argon-Mischung kontinuierlich oder schrittweise verändert wird. Wenn der erste Teil der Schicht abgeschieden ist, kann ohne Qualitätsverlust der Heliumanteil zurückgenommen werden, um die Abscheidung gegen Ende hin beispielsweise mit reinem Argon und immer höher werdender Zerstäubungsausbeute durchführen zu können. Dieses Ergebnis wird gemäss Vorgehen nach Anspruch 3 erreicht. Besonders günstige Bedingungen bezüglich Haftung und schonender Beschichtung werden erreicht, wenn das Helium-Argon-Gasgemisch ein Mischverhältnis im Bereich von 2 bis 20 aufweist, wie dies in Anspruch 5 vorgeschlagen wird.

Um den Beschichtungsvorgang weiter zu beschleunigen ohne die günstigen Abscheideeigenschaften aufs Spiel zu setzen, wird ein Vorgehen nach Anspruch 6 vorgeschlagen. Um die Reaktion der Restgasanteile entsprechend kontrollieren zu können, ist neben dem Variieren des Helium-Argon-Gasgemisches auch ein Variieren der Zerstäubungsleistung möglich. Besonders einfach kann dies durchgeführt werden, indem gemäss Anspruch 7 die Leistung in Schritten eingestellt wird. Bei dem vorliegenden Verfahren ist es nicht notwendig, zwischen den Leistungsschritten den Vorgang zu unterbrechen. Diese können gemäss Vorgehen nach Anspruch 8 ohne Unterbrechung der Plasmaentladung eingestellt werden. Die Reaktion der Restgase zur Erzeugung einer haftungsvermittelnden Schicht soll vorzugsweise mit geringer Leistung erfolgen. Um anschliessend möglichst rasch die erforderliche Schichtdicke des aufzubringenden Metalles zu erreichen, kann dann die Leistung entsprechend erhöht werden, wie dies gemäss Vorgehen nach Anspruch 9 vorgeschlagen wird. Besonders einfach wird die Durchführung des Verfahrens wenn beispielsweise ein geeignetes Gasmischungsverhältnis für das ganze Verfahren konstant eingestellt wird und nur die Zerstäubungsleistung in zwei Schritten eingestellt wird, wobei wie bereits erwähnt der zweite Schritt mit höherer Leistung ausgeführt wird.

Besonders schwierig ist die Metallabscheidung auf Kunststoffwerkstücke der Gruppe der Poly(methyl)Acrylate. Insbesondere von PMMA (Polymethylmetacrylat). Für die Erzeugung einer reproduzierbar haftfesten Schicht müssen, wie bereits erwähnt, besondere Massnahmen getroffen werden. Diese Massnahmen dürfen allerdings in speziellen Anwendungsfällen die Oberfläche der Kunststoffwerkstücke nicht unzulässig beeinflussen und deformieren. Insbesondere bei der Herstellung von optischen Speicherplatten, wie Videoplatten oder auch Kompaktdiskplatten, wo die Informationen durch Einprägung in die Kunststoffplatte festgehalten sind, ist ein sehr schonendes Beschichtungsverfahren notwendig, um keinen unzulässigen Signalverlust bei der Laserabtastung zu erhalten. Das vorgeschlagene Verfahren eignet sich hierhierzu besonders gut, wobei gleichzeitig Dank der einfachen Realisierbarkeit des Verfahrens eine hohe Wirtschaftlichkeit bei der Produktion von grossen Stückzahlen erreicht werden kann. Bevorzugterweise werden als metallische Schichten Materialien mit hoher Reflexion wie beispielsweise Aluminium oder dessen Legierungen abgeschieden. Die abgeschiedene Schicht hat hierbei die Aufgabe, hohe Reflexionswerte für den Laserstrahl zur Verfügung zu stellen. Hierzu sind Schichtdicken nötig im Bereich von etwa 50 Nanometer. Diese Schichten sollen bei den heute üblichen Produktionsdurchsätzen innert weniger Sekunden abgeschieden werden können. Das erfindungsgemässe Verfahren ist besonders geeignet, die hohen Anforderungen bei der Beschichtung von PMMA-Speicherplatten zu erfüllen. Die Anforderung für die Schichthaftung ist in der USA- Spezifikation 4 MIL-C-48497 (MU) festgelegt und wird vom vorgeschlagenen Verfahren sogar übertroffen. Als weiterer Vergleichsstandard werden die Messergebnisse verglichen, welche mit dem bis anhin üblichen Aufdampfverfahren hergestellt worden sind. PMMA-Platten, welche beispielsweise mit einem thermischen Verdampfersystem beschichtet worden sind, zeigen nämlich eine sehr gute Haftung der Schicht ohne das Kunststoffmaterial wesentlich zu beeinträchtigen. Deshalb können neben dem MIL-Standard die Werte von Platten, welche mit dem Aufdampfverfahren erreicht werden, als Vergleichsbasis herangezogen werden. In diesem Fall soll das Signalrauschverhältnis bei der Signalauswertung durch die Laserabtastung einen geringeren Verlust als 2 dB gegenüber der aufgedampften Schicht aufweisen, wobei die Reflexionswerte an der Schicht mehr als 70% betragen müssen.

Die Durchführung des erfindungsgemässen Verfahrens erfolgt in einer Vakuumkammer, in welcher Vakuumprozesse durchgeführt werden können. Hierzu ist diese mit einer steuerbaren Abpumpvorrichtung versehen, zur Erzeugung der vorgesehenen Arbeitsdrücke bei entsprechend vorgebbarem Prozessgasdurchsatz. Für die Zuführung der Prozessgase ist die Anlage mit einer steuerbaren Gaseinlassanordnung verbunden, welche von Gasbehältern gespiesen wird. Mit Hilfe einer Magnetron-Zerstäubungsquellenanordnung, welche an die Vakuumkammer an- oder auch eingebaut ist, wird das zu beschichtende Metall mit Hilfe des bekannten Plasmazerstäubungsvorganges in dampfförmigen Zustand gebracht und auf das Werkstück abgeschieden. Zu diesem Zweck wird die Magnetronzerstäubungsquelle mit einer steuerbaren Stromversorgung gespeist. Es können auch mehrere Magnetronzerstäubungsquellen und mehrere Stromversorgungen verwendet werden. Für die Automatisierung des Herstellungsprozesses ist es vorteilhaft, zur Beschickung der Vakuumkammer eine Zuführ- und Wegführvorrichtung vorzusehen, welche das Werkstück in der Vakuumkammer in Prozessposition bringt und nach erfolgtem Prozess wieder aus der Vakuumkammer wegführt. Um alle diese Vorgänge entsprechend koordiniert ablaufen zu lassen, wird eine Steuereinrichtung vorgesehen. Insbesondere soll diese Steuereinrichtung neben der Vakuumerzeugung und der Belade- und Entladevorrichtung den Vakuumprozess steuern, indem diese auf die Gaseinlassanordnung und die Stromversorgungsanordnung einwirkt. In einfacheren Fällen kann es auch genügen, wenn nur die Gaseinlassanordnung oder die Stromversorgungsanordnung gesteuert wird. Beispielsweise dann, wenn mit einem festen Gasgemisch gearbeitet wird und dieses während des Prozessvorganges nicht verändert wird. Solche als Prozesssteuerungen bekannte Steuereinrichtungen müssen mindestens eine Speichereinrichtung umfassen, um die Daten nach dem vorgegebenen Zeitablauf der Prozessführung, insbesondere für die Steuerung der Gaseinlassanordnung und der Stromversorgungsanordnung aufnehmen und speichern zu können. Bei der Beschichtung von optischen Speicherplatten zur Erzeugung einer metallischen Reflexionsschicht, hat sich die Verwendung einer Magnetron- Zerstäubungsquellenanordnung, bei welcher die Kathode oder die Kathoden aus Alumium oder Aluminiumlegierungen besteht, besonders bewährt. Die beschriebene Anlagenanordnung ist ausserdem speziell geeignet Speicherplatten, welche aus PMMA-Kunststoffen besteht, zu beschichten. Bevorzugte Ausführungsvarianten des erfindungsgemässen Verfahrens zeichnen sich nach den Ansprüchen 7 bis 13 aus.

Die Erfindung wird anschliessend beispielsweise anhand von Figuren und Beispielen erläutert.

Die drei Figuren zeigen:
Figur 1:
   Schematisch und im Querschnitt eine Anordnung zur Durchführung des Beschichtungsverfahrens mit einer Zu- und Wegführvorrichtung für das Werkstück, aber ohne zusätzliche Einschleusvorrichtung in die Vakuumkammer.
Figur 2:
   Schematisch und im Querschnitt eine Anordnung zur Durchführung des Beschichtungsverfahrens mit einer Zu- und Wegführvorrichtung für das Werkstück, aber mit zusätzlicher Einschleusvorrichtung für das Werkstück in die Vakuumkammer.
Figur 3:
   Ein Prozessablauf-Diagramm, welches zeigt, wie bespielsweise die Gaszuführungen und die Leistungszufuhr für die Magnetron- Zerstäubungsquelle zeitlich gesteuert werden kann.

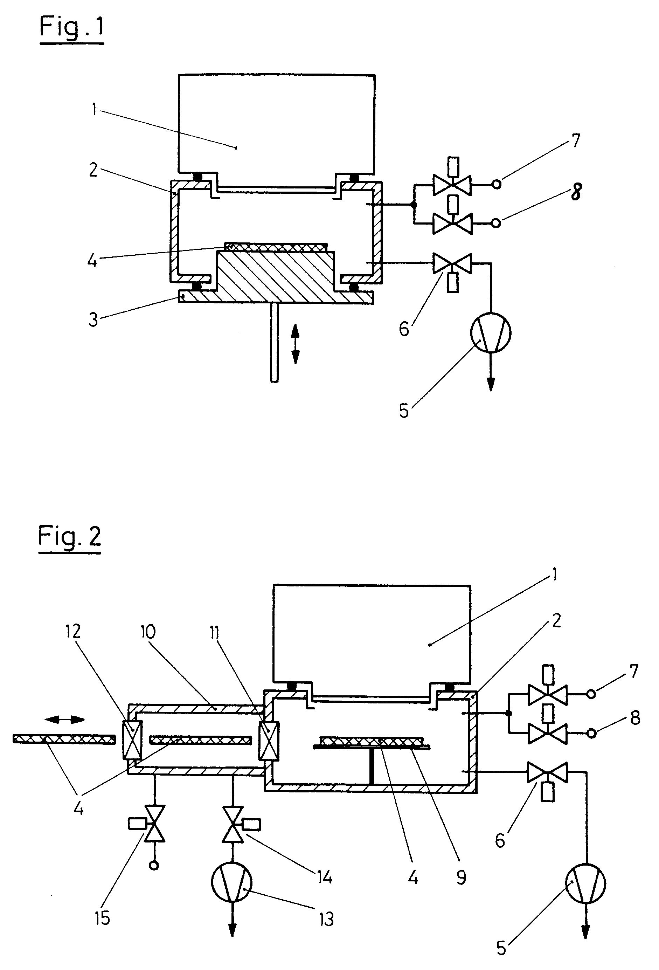

Die Figur 1 zeigt eine sehr einfache Anlagenkonfiguration im Schnitt, in welcher das erfindungsgemässe Verfahren durchgeführt werden kann. An der Anlagenkammer 2 befindet sich eine Oeffnung an welcher eine planare Magnetronquelle 1 (PM) vakuumdicht angebaut ist. An der gegenüberliegenden Seite zur Magnetronquelle befindet sich eine weitere Oeffnung in der Vakuumkammer 2, welche erlaubt, das Werkstück über eine Hubeinrichtung 3, welche gleichzeitig die Vakuumkammer dichtend abschliesst, in Arbeitsposition mit einigen Zentimetern Abstand gegenüber der Magnetronquelle zur Beschichtung zu bringen. Die Vakuumkammer 2 ist verbunden mit einer Abpumpvorrichtung 5, 6 sowie mit Gaseinlassvorrichtungen 7, 8 verbunden für die Zuführung der Prozessgase. Die Gaszuführvorrichtungen sind mit den entsprechenden Gasbehältern verbunden, welche in der Figur nicht dargegestellt sind. Beim Bestücken der Anlage mit einem Werkstück 4, ist die Beladevorrichtung 3 in abgesenkter Position. Die Beladevorrichtung 3 wird nach Bestücken mit einem Werkstück 4 angehoben und an die Kammer 2 gepresst, wobei diese abgedichtet wird. Danach wird die Pumpvorrichtung 5 und 6 zugeschaltet und die Anlage evakuiert, bis der Prozessgasdruck von beispielsweise einigen 10⁻³ Millibar erreicht wird. Die Gaszuführung ist beim ganzen Vorgang sowohl bei offener Anlage, wie auch bei geschlossener Anlage dauernd in Betrieb. Bei offener Anlage wird damit ein Gasspülungseffekt erzielt, um die Luft möglichst von der Vakuumkammer fernzuhalten und um kurze Abpumpzeiten zu erreichen bei hinreichender Vakuumqualität. Eine Drosselung einzelner Gase ist fallweise möglich. Nach dem Abpumpen der Vakuumkammer 2, sorgt die Steuerung dafür, dass die Prozessgase auf das richtige Mischungsverhältnis eingestellt werden wenn nicht mit fest eingestellten Werten gearbeitet wird. Danach wird die Zerstäubungsquelle 1 eingeschaltet und entsprechend den Vorgaben der Steuerung das Leistungsprofil gefahren, bis die Schichtabscheidung zu Ende ist, mit abschalten der Stromversorgung. Danach wird die Pumpvorrichtung 5, 6 von der Vakuumkammer 2 abgetrennt und die Beladestation abgesenkt zur Entfernung des beschichteten Werkstückes. Danach kann wieder ein neuer Beschichtungszyklus erfolgen.

In Figur 2 ist schematisch ein Querschnitt durch eine Beschichtungsvorrichtung dargestellt, welche gegenüber Figur 1 eine Einschleusvorrichtung aufweist. Diese Einschleusvorrichtung erhöht die Vakuumqualität und somit die Beschichtungsqualität zusätzlich, da Fremdgase wie Luft und Wasserdampf besser kontrolliert werden können. Neben der Beschichtungskammer, wie dies in Figur 1 dargestellt ist, ist in Figur 2 zusätzlich eine Schleusenkammer 10 mit den Ventilen 11, 12 der Abpumpvorrichtung 13, 14 sowie eine zusätzliche Gaseinlassvorrichtung 15 für eine eventuelle Gasspülung beim Oeffnen dargestellt. Das Werkstück 4 wird über eine Zu- beziehungsweise Wegführvorrichtung durch die Schleuse in die Vakuumkammer 2 transportiert, wo das Werkstück 4 auf die Unterlage 9 für die Behandlung abgelegt wird. Nach Figur 2 erfolgt die Einschleusung des Werkstückes 4 beispielsweise horizontal. Verwendbar sind aber auch Anordnungen, welche das Werkstück vertikal transportieren. Ebenso sind Anordnungen verwendbar, welche mehr als eine Schleusenkammer vorsehen, um den Ein- und Ausschleusvorgang weiter zu beschleunigen.

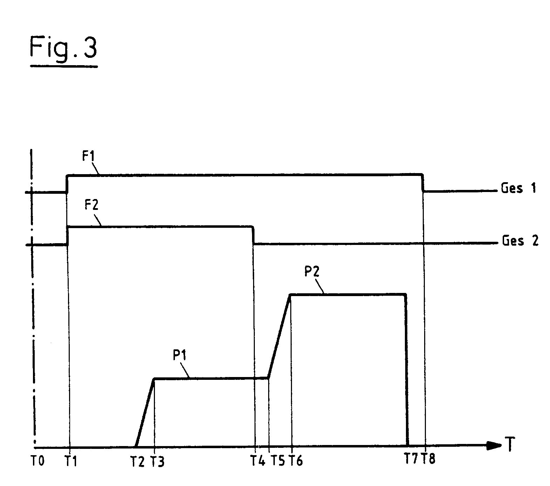

In Figur 3 wird ein möglicher und besonders einfacher Prozessablauf bezüglich Gasführung und Leistungssteuerung der Plasmaentladung für den Beschichtungsablauf dargestellt. Nach Positionierung des Werkstückes in der Vakuumkammer und nach Erreichung eines bestimmten Vakuumdruckes wird beim Zeitpunkt T₁ das Gas F₁, beispielsweise Argon und das Gas F₂, beispielsweise Helium, zugeschaltet. Das eingestellte Mischungsverhältnis der Gasmassenflüsse von F₂ zu F₁ beträgt typischerweise 2 bis 20. Nach einer kurzen Einstellzeit, wird bei T₂ die Stromversorgung der Magnetronzerstäubungsquelle eingeschaltet und auf die Leistung P₁ gebracht. Das Hochfahren auf die Leistung P₁ erfolgt in der Zeit T₂ bis T₃ und kann wahlweise sehr kurz oder über eine längere Zeit eingestellt werden. Beim erfindungsgemässen Verfahren wird diese Zeit vorteilhaft sehr kurz gewählt. Während der Zeit T₃ bis T₅, welche typischerweise im Bereich von 1 bis 10 Sekunden abläuft, findet die Vorbehandlung mit reduzierter Leistung statt, welche typischerweise im Bereich von 5 bis 50% des nachfolgenden Leistungswertes P₂ beträgt, wo der wesentliche Anteil der metallischen Abscheidung der Aluminiumschicht erfolgt. Bei T₄ kurz vor Erhöhen der Zerstäubungsleistung auf P₂ kann das Gas F₂ beispielsweise Helium, reduziert werden oder abgeschaltet werden, um die Zerstäubungsrate der nachfolgend aufgebrachten Metallschicht nicht unnötig zu behindern. Zwischen T₅ und T₆ wird die Zerstäubungsleistung weiter erhöht auf die Maximalleistung P₂, beispielsweise 20 Kilowatt, wobei im Zeitraum T₆ bis T₇ typischerweise innerhalb etwa 2 bis 6 Sekunden die metallische Schicht abgeschieden wird. Bei T₇, wo die gewünschte Schichtdicke von beispielsweise 50 Nanometer, erreicht wird, wird die Zerstäubungsquelle ausgeschaltet und bei T8 das Gas F1 ausgeschaltet. Danach wird das Werkstück aus der Anlage weggeführt und ein neues, für einen nächsten Beschichtungszyklus, zugeführt. Da dieser Beschichtungsprozess als Ein-Schritt-Prozess und Ein-Kammer-Prozess als zusammenhängender Schritt zur Erzeugung einer haftfesten Schicht durchgeführt werden kann, ergeben sich äusserst vorteilhaft kurze Zykluszeiten von wenigen Sekunden, was zu einer hohen Wirtschaftlichkeit des Produktionsverfahrens führt. Ausserdem ergeben sich kurze Abpumpzeiten, da nicht wie üblicherweise ein Konditionierungsschritt zur Entgasung der Werkstücke notwendig ist. Mit Hilfe der Einstellung des Gasmischungsverhältnisses und der Leistungsbedingungen, kann kann die Abscheidung der Schicht auf einfache Weise kontrolliert und eingestellt werden. Zur Festlegung der besten Werte genügen wenige Versuchsschritte. Die erfindungsgemäss verwendete Gasmischung verursacht keine Verunreinigungsprobleme. Es können keine unangenehmen und schädlichen Verunreinigungen und Ablagerungen in der Vakuumkammer an der Zerstäubungsquelle oder auch an dem Werkstück entstehen. Bei der Beschichtung von Speicherplatten werden die optischen und die elektrischen Daten nicht unzulässig beeinflusst.

### Beispiele:

Auf je eine Speicherplatte aus PMMA wurde eine Aluminiumschicht abgeschieden. Die eingestellten Verfahrensparameter für verschiedene Versuchseinstellungen gehen aus Tabelle 1 hervor. Die Beispiele 1 bis 4 entsprechen dem erfindungsgemässen Vorgehen. Die Beispiele 5 und 6 entsprechen dem Vorgehen nach dem Stand der Technik. Bei den Beispielen wurde das typische Saugvermögen in der Prozesskammer auf einen Durchsatz von 50 bis 200 liter/sekunde eingestellt.

**Tabelle 1**

| Versuch | 1 | 2 | 3 | 4 | 5 | 6 |
|---|---|---|---|---|---|---|
| He Fluss F₂ [sccm] | 180 | 180 | 50 | 180 | 0 | |
| Ar Fluss F₁ [sccm] | 20 | 35 | 30 | 10 | 30 | 30 |
| Leistung P₁ [kW] | 6 | 6 | 6 | 4 | 6 | 0 |
| Zeit T₃ - T₅ [s] | 3 | 3 | 8 | 6 | 10 | 0 |
| Leistung P₂ [k]) | 20 | 20 | 15 | 15 | 18 | 18 |
| Zeit T₆-T₇ [s] | 6 | 6 | 1 | 6 | 3 | 4 |
| Haftung [%] | 80-100 | 70-90 | 60-80 | 80-100 | 0-20 | 0-40 |

In Tabelle 2 werden die Wertebereiche zum Vergleich mit dem Aufdampfstandard angegeben.

**Tabelle 2**

| | Haftung [%] | Reflexion [%] | S/N Änderung (vor Klimatest) [dB] | Klimatest |
|---|---|---|---|---|
| Aufdampfreferenz | 100 | 82 | 0 | gut |
| Erfindungsgemäses Verfahren | 70-100 | 70-82 | 0,2 - 2,0 | gut |
| (Die angegebenen Werte sind typische Werte) | | | | |

Die für die Schichthaftungsmessung verwendete Methode entspricht MIL-C-48497 (MU) und wird durch Abziehen eines Klebbandes vorgenommen. Die Werte entsprechen dem Verhältnis zwischen der abgezogenen Schichtfläche und der Klebbandfläche.

Der verwendete Klimatest entspricht der Norm IEC 856. Hierbei werden die Testmuster während 4 Tagen bei 45° C in einer Umgebung mit bis zu 90 % relativer Luftfeuchtigkeit gelagert.

Daraus ist ersichtlich, dass eine gute Schichthaftung und Klimabeständigkeit bei minimaler Änderung der Reflexionswerte und der Signal zu Rauschverhältnisse (S/N) gegenüber den besten erweichbaren Werten mit dem Aufdampfverfahren, nun erfindungsgemäss auch mit einem Zerstäubungsverfahren bei hoher Wirtschaftlichkeit, erreicht werden kann.

## Patentansprüche

1. Verfahren zur Beschichtung eines Werkstückes aus Kunststoff mit einer Metallschicht in einer Vakuumkammer mit Hilfe der Magnetron-Kathodenzerstäubung, wobei die Plasmaentladung der Zerstäubungskathode mit Argon betrieben wird dadurch gekennzeichnet, dass die Plasmaentladung zusätzlich mit mindestens einem weiteren Edelgas als Gasgemisch betrieben wird.

2. Verfahren nach Anspruch 1, dadurch gekennzeichnet, dass die Plasmaentladung der Zerstäubungskathode mit einem Helium-Argon-Gasgemisch betrieben wird.

3. Verfahren nach Anspruch 1 oder 2, dadurch gekennzeichnet, dass das Gasmischungsverhältnis während dem Plasmaentladungsvorgang variiert wird.

4. Verfahren nach Anspruch 3, dadurch gekennzeichnet, dass das Gasmischungsverhältnis für die Plasmaentladung mindestens auf einen festen Wert eingestellt wird.

5. Verfahren nach Anspruch 3 oder 4, dadurch gekennzeichnet, dass das Edelgas- Argon Gasgemisch ein Massenfluss-Mischverhältnis im Bereich von 2 bis 20 aufweist.

6. Verfahren nach Anspruch 5, dadurch gekennzeichnet, dass die elektrische Leistung der Zerstäubungseinrichtung während dem Beschichtungsvorgang variiert wird.

7. Verfahren nach Anspruch 6, dadurch gekennzeichnet, dass die Beschichtung mit mindestens zwei unterchiedlichen Betriebsleistungen erfolgt.

8. Verfahren nach Anspruch 7, dadurch gekennzeichnet, dass beim Leistungswechsel keine Unterbrechung der elektrischen Leistungszufuhr der Zerstäubungseinrichtung erfolgt.

9. Verfahren nach Anspruch 6 bis 8, dadurch gekennzeichnet, dass die Plasmaentladung zu Beginn während einer vorgegebenen Zeit mit reduzierter Leistung betrieben wird.

10. Verfahren nach Anspruch 1 bis 9, dadurch gekennzeichnet, dass das Werkstück aus dem Material PMMA besteht.

11. Verfahren nach Anspruch 10, dadurch gekennzeichnet, dass das PMMA Werkstück als Speicherplatte ausgebildet ist.

12. Verfahren nach Anspruch 11, dadurch gekennzeichnet, dass die abgeschiedene Schicht aus einem hochreflektierenden Metall vorzugsweise aus Aluminium oder Aluminiumlegierungen besteht.

13. Verfahren nach Anspruch 12, dadurch gekennzeichnet, dass die Gasdrucke, die Gasmischungsverhältnisse und die Leistungseinstellungen der Plasmaentladung so eingestellt werden, dass die Schichthaftung die Anforderung MIL-C-48497 (MU) erfüllt und das Signal-Rauschverhältnis der Speicherplatte weniger als 2 dB Verlust gegenüber dem Aufdampfstandard aufweist und dass die Reflexion an der Schicht über 70% beträgt.

## Claims

1. Method to coat a plastic material workpiece with a metal layer in a vacuum chamber by means of magnetron cathodic sputtering where the plasma discharge of the sputtering cathode is operated with argon characterized in that the plasma discharge in addition is operated with a gas mixture consisting of at least one further inert gas.

2. Method as claimed in claim 1 characterized in that the plasma discharge of the sputtering cathode is operated with a helium-argon gas mixture.

3. Method as claimed in claim 1 or 2 characterized in that the gas mixture ratio is varied during the plasma discharge process.

4. Method as claimed in claim 3 characterized in that the gas mixture ratio for the plasma discharge is set to at least one fixed value.

5. Method as claimed in claim 3 or 4 characterized in that the inert gas-argon gas mixture has a flow rate-mixing ratio in the range of about 2 through 20.

6. Method as claimed in claim 5 characterized in that the electrical power of the sputtering device is varied during the coating process.

7. Method as claimed in claim 6 characterized in that the coating is proceeded with at least two different operation power levels.

8. Method as claimed in claim 7 characterized in that there is no interruption of the electrical power supply of the sputtering device when the power is changed.

9. Method as claimed in claim 6 through 8 characterized in that the plasma discharge at the beginning is operated at a reduced power during a preset time period.

10. Method as claimed in claim 1 through 9 characterized in that the workpiece consists of PMMA material.

11. Method as claimed in claim 10 characterized in that the PMMA workpiece functions as a storage disk.

12. Method as claimed in claim 11 characterized in that the evaporated layer consists of a highly reflecting metal, preferably aluminum or aluminum alloys.

13. Method as claimed in claim 12 characterized in that the gas pressures, the gas mixture ratios and the power settings of the plasma discharge are set so that the adhesion strength of the layer meets the MIL-C-48497 (MU) requirement and that the signal to noise ratio of the storage disk amounts to less than a 2 dB loss relative to the evaporation standard and that the reflection at the layer is more than 70%.

## Revendications

1. Procédé de revêtement d'une pièce à traiter en matière plastique au moyen d'une couche métallique dans une chambre sous vide à l'aide d'une pulvérisation cathodique par magnétron, la décharge de plasma de la cathode de pulvérisation étant effectuée à l'aide d'argon, caractérisé en ce que la décharge de plasma est effectuée en utilisant en outre au moins un autre gaz rare en tant que mélange gazeux.

2. Procédé selon la revendication 1, caractérisé en ce que la décharge de plasma de la cathode de pulvérisation est effectuée avec un mélange gazeux d'hélium-argon.

3. Procédé selon la revendication 1 ou 2, caractérisé en ce que le rapport de mélange des gaz est modifié pendant le processus de décharge de plasma.

4. Procédé selon la revendication 3, caractérisé en ce que le rapport de mélange des gaz pour la décharge de plasma est réglé au moins à une valeur fixe.

5. Procédé selon la revendication 3 ou 4, caractérisé en ce que le rapport de mélange, en débit massique, du mélange gazeux gaz rare-argon est compris dans la zone de 2 à 20.

6. Procédé selon la revendication 5, caractérisé en ce que la puissance électrique du dispositif de pulvérisation est modifiée pendant le processus de revêtement.

7. Procédé selon la revendication 6, caractérisé en ce que le revêtement est effectué avec au moins deux puissances différentes de fonctionnement.

8. Procédé selon la revendication 7, caractérisé en ce qu'aucune interruption de l'amenée de puissance électrique au dispositif de pulvérisation ne se produit lors du changement de puissance.

9. Procédé selon l'une des revendications 6 à 8, caractérisé en ce que la décharge de plasma est effectuée à puissance réduite à l'origine pendant un temps prédéterminé.

10. Procédé selon l'une des revendications 1 à 9, caractérisé en ce que la pièce à traiter est en polyméthacrylate de méthyle, ou PMMA.

11. Procédé selon la revendication 10, caractérisé en ce que la pièce à traiter en polyméthacrylate de méthyle est réalisée sous forme de disque de mémoire.

12. Procédé selon la revendication 11, caractérisé en ce que la couche déposée se compose d'un métal hautement réfléchissant, de préférence de l'aluminium ou des alliages d'aluminium.

13. Procédé selon la revendication 12, caractérisé en ce que les pressions de gaz, les rapports de mélange gazeux et les réglages de puissance de la décharge de plasma sont réglés d'une manière telle que l'adhérence de couche répond à la norme MIL-C-48497 (MU) et le rapport signal sur bruit du disque de mémoire présente une perte inférieure à 2 dB par rapport à la norme de métallisation sous vide et la réflection sur la couche dépasse 70%.
